Europäisches Patentamt

European Patent Office

Office européen des brevets

(11) Veröffentlichungsnummer: **0 014 441**
**A1**

(12) **EUROPÄISCHE PATENTANMELDUNG**

(21) Anmeldenummer: 80100491.2

(22) Anmeldetag: 31.01.80

(51) Int. Cl.³: **G 01 D 15/18**
**G 01 R 17/06**

(30) Priorität: **07.02.79 DE 2904595**

(43) Veröffentlichungstag der Anmeldung:
**20.08.80 Patentblatt 80/17**

(84) Benannte Vertragsstaaten:
**AT CH FR IT NL SE**

(71) Anmelder: **Hellige GmbH**
**Postfach 728 Heinrich-von-Stephan-Strasse 4**
**D-7800 Freiburg(DE)**

(72) Erfinder: **Orzikowski, Günter**
**Altschlössleweg 5**
**D-7801 Au (bei Freiburg i.Br.)(DE)**

(74) Vertreter: **ter Meer, Nicolaus, Dipl.-Chem.Dr. et al,**
**Patentanwälte ter Meer, Müller, Steinmeister**
**Triftstrasse 4**
**D-8000 München 22(DE)**

(54) Flüssigkeitsstrahlschreiber.

(57) Die Erfindung sieht vor, den Dauermagneten (3) des elektromagnetischen Antriebs eines Flüssigkeitsstrahlschreibers über ein steifes Kopplungselement (4) starr mit einer Ankoppelstelle (1) der Tintenführungskapillare (6) zu verbinden und die Ankopplungsstelle so nahe wie möglich an die Strahlaustrittsdüse zu legen, so daß Auslenkfehler durch Taumelbewegungen der Düse und dergleichen innerhalb des Reststücks zum Strahlaustritt ausgeschlossen sind. Das an der Ankopplungsstelle (1) vorzugsweise durch Verkleben starr mit der Kapillare (6) verbundene Kopplungselement (4) hat die weitere Aufgabe, den an der Ankopplungsstelle (1) abgreifbaren Ist-Wert der Austrittsdüsenauslenkung an den Meßwertaufnehmer zu übertragen; es ist vorzugsweise ein die Kapillare im unteren Bereich umgebendes Glasröhrchen, das vor und hinter dem Dauermagneten (3) drehbar gelagert ist. Mit der Erfindung wird eine wesentliche Verbesserung der Meßgüteklasse bei Flüssigkeitsstrahlschreibern erreicht.

-1-

von Flüssigkeitspumpe

PATENTANWÄLTE
# TER MEER-MÜLLER-STEINMEISTER

**Beim Europäischen Patentamt zugelassene Vertreter — Professional Representatives before the European Patent Office**
**Mandataires agréés près l'Office européen des brevets**

Dipl.-Chem. Dr. N. ter Meer   Dipl.-Ing. H. Steinmeister
Dipl.-Ing. F. E. Müller
Triftstrasse 4,                Siekerwall 7,
D-8000 MÜNCHEN 22             D-4800 BIELEFELD 1

PW-P 415-EP                              31. Januar 1980
Mü/vL


HELLIGE GMBH

Heinrich-von-Stephan-Str. 4

7800 Freiburg/Breisgau

---

Flüssigkeitsstrahlschreiber

---


Erfindungsgegenstand ist ein Flüssigkeitsstrahlschreiber gemäß dem Oberbegriff des Patentanspruchs 1.

Gegenüber Hebelschreibern haben Flüssigkeitsstrahlschreiber für die analoge Aufzeichnung von Meßgrößen in Form der Amplitudenkurven, etwa in der Medizintechnik bei EEG-

- 2 -

und EKG-Geräten, den Vorteil einer relativen Trägheitslosigkeit, so daß Frequenzen bis ca. 1200 Hz aufgezeichnet werden können. Außerdem arbeiten solche Flüssigkeitsstrahlschreiber geräuschlos, und ihr Amplitudenbereich
ist nicht an eine bestimmte Schreibbreite gebunden, vielmehr können die aufgezeichneten Amplitudenkurven sich
überlappen.

Durch die deutsche Patentschrift 821 065 ist ein Flüssigkeitsstrahlschreiber bekannt, bei dem das der Zuführung
und Beförderung der Schreibflüssigkeit - der Tinte - vom
Vorratsbehälter über eine Pumpe zur Schreibdüse dienende
Kapillarröhrchen über zwei parallele Drahtstege mit einer
Schleife aus Silberdraht verbunden ist, die sich im Magnetfeld eines Dauermagneten befindet. Entsprechend dem
von der aufzuzeichnenden Meßgröße gesteuerten elektrischen
Strom in der Drahtschleife wird die abgebogene Schreibstrahl-Austrittsdüse des Kapillarröhrchens ausgelenkt.
Wegen des relativ großen Dauermagneten ist dieser vergleichsweise lange bekannte Strahlschreiber für die meisten heutigen Anforderungen räumlich zu groß, weil oftmals der
Wunsch besteht, eine Vielzahl von Kurvenscharen nebeneinander in Relation zur gleichen Zeitachse aufzeichnen zu
können, so daß mehrere dieser Schreibwerke dicht nebeneinander anzuordnen sind. Dieser bekannte Flüssigkeitsstrahlschreiber ist zudem auch sehr kompliziert im Aufbau.

In der DE-OS 26 19 369 ist ein Flüssigkeitsstrahlschreiber neuerer Bauart beschrieben, bei dem auf die Kapillare vor ihrem die Austrittsdüse für die Schreibflüssigkeit
bildenden abgewinkelten Ende ein kleiner, diametral magnetisierter Dauermagnet aufgeklebt ist, der sich zwischen zwei Polschuhen aus Weicheisen befindet. Dabei hat der Elektromagnet, mit dem die beiden Polschuhe verbunden sind, die Form von zwei koaxial das Kapillarrohr umschließenden Röhrchen, zwischen welchen die Erregerspule angeordnet ist, um einen raumsparenden Aufbau zu erzielen. Der mit dem Ende der Kapillare verbundene, zwischen den Polen des Elektromagneten angeordnete Permanentmagnet befindet sich bei dieser bekannten Ausführung in einem mit Dämpfungsflüssigkeit gefüllten Röhrchen, das beidseitig durch Lager für die Kapillare verschlossen ist.

Gegenüber dem erstgenannten Typ von Flüssigkeitsstrahlschreibern hat der zweitgenannte Schreiber den Vorteil, daß er in sehr kompakter Bauweise hergestellt und deshalb eine Vielzahl von Schreibwerken dicht nebeneinander angeordnet werden kann. Extreme Anforderungen werden jedoch an die Fertigungsgenauigkeit nicht nur beim Einbringen der Kapillare in das mit Lagern versehene Außenrohr, sondern auch beim Aufkleben des Dauermagneten auf die Kapillare gestellt. Bei den für solche Strahlenschreiber verwendeten Kapillaren handelt es sich um äußerst dünne Glasröhrchen, deren Außendurchmesser in der Größenordnung des Durchmessers eines menschlichen Haars liegt. Um möglichst gleiche Toleranzen bei allen Strahlschreibwerken eines Vielkurvenschreibers gewährleisten zu können, werden nicht nur sehr enge Fertigungstoleranzen beim Ziehen der Kapillaren, sondern insbesondere auch beim Aufkleben der Dauermagneten vor dem abgebogenen Ende der Kapillare verlangt. Ein weiterer prinzipieller Nachteil, der auch für Flüssigkeitsstrahlschreiber nach der erstgenannten DE-PS vorliegt, besteht darin, daß die Kapillare nicht nur zur Zuführung der Schreibflüssigkeit von einer Flüssigkeitspumpe dient, sondern bei der Torsionsbeanspruchung außerdem die mechanische Rückstellkraft des Schreibwerks liefern soll. Weil die Kapillare außer zur Tintenführung auch als Rückstellfeder wirkt, bestimmt sie zusammen mit dem Dauermagneten im wesentlichen die Grenzfrequenz, weshalb bestimmte Werte bei den Eigenschaften
des Glases der Kapillare auf der ganzen Länge der Kapillare sehr genau eingehalten werden müssen. Eine äußerst
diffizile Justierung für den Antrieb des Schreibsystems
ist damit unumgänglich.

Trotz enger Fertigungstoleranzen erreicht man mit
solchen bekannten Flüssigkeitsstrahlschreibern nur die
Meßgüte-Klasse 2,5, d.h. die aufgezeichneten Meßwerte sind
mit einer Fehlerabweichung von 2,5 %, bezogen auf den Endausschlag, behaftet. Im Gegensatz dazu lassen sich beispielsweise bei Hebelschreibern Güteklassen von 0,5 erreichen.

Abgesehen von den Schwierigkeiten, die sich aus der
Doppelfunktion der Glaskapillare ergeben, nämlich als Tintenführung und als Rückstellfeder zu dienen, liegt eine
wesentliche Ursache der relativ unbefriedigenden Güteklasse
in der ein erhebliches Stück über den Antriebsmagneten
hinausragenden freitragenden Schreibspitze, die in Strahlaustrittsrichtung stromab von dem Dauermagneten nur
schlecht geführt werden kann, wobei das Lager am Schreibende der Kapillare eigentlich nur als Anschlagelement zur
Verhinderung von Taumelbewegungen der Schreibspitze dienen
kann. Der so bestehende relativ große Abstand zwischen
der von der Lage des Dauermagneten bestimmten Antriebs-
oder Auslenkstelle und derjenigen Stelle, wo die Kapillare

- 5 -

in die senkrecht dazu verlaufende Austrittsdüse umgeknickt ist, ist deshalb eine wesentliche Ursache für die noch unbefriedigende Genauigkeit bei solchen bekannten Tintenstrahlschreibern.

Der im Patentanspruch 1 gekennzeichneten Erfindung liegt damit die Aufgabe zugrunde, Flüssigkeitsstrahlschreiber so zu verbessern, daß bei verringertem Fertigungs- und Justieraufwand trotzdem eine höhere Güteklasse des Schreibwerks erreicht werden kann, als dies bisher möglich ist. Insbesondere soll zu diesem Zweck die der Zuführung der Schreibflüssigkeit von der Förderpumpe zur Austrittsdüse dienende Kapillare mindestens von einer der anderen mechanischen Aufgaben, die sie bisher noch hatte, weitestgehend entlastet werden. Diese bisherigen Aufgaben sind: Halterung und Positionierung der Austrittsdüse, Halterung des Permanentmagneten zwischen den Polen des Elektromagneten; Übertragung des Drehmoments zur Auslenkung der Austrittsdüse für die Schreibflüssigkeit vom Permanentmagneten auf das Ende der Kapillare, an welchem sie in die Austrittsdüse umgeknickt ist; schließlich die Lieferung der Rückstellkraft durch die Torsion der Kapillare gegenüber dem vom Permanentmagneten ausgeübten Drehmoment.

Schon in dieser Forderung nach weitgehender mechanischer Entlastung der Förderkapillare für die Schreibflüssigkeit liegt ein wesentlicher Grundgedanke der vorliegenden Erfindung. Eine Maßnahme, welche bereits entscheidend zur Erfüllung dieser Forderung beiträgt, ist die Kontrolle des unter der Wirkung des vom Permanentmagneten übertragenen Drehmoments erreichten Drehwinkels der Kapillare durch eine Rückführungsvorrichtung. Bekanntlich wirkt eine Rückführung wie eine mechanische Rückkoppelung durch eine Regelvorrich-

**0014441**

- 6 -

tung, wobei der Ist-Wert der Regelgröße - hier die Winkelstellung am Ende der Kapillare - nach mechanisch-elektrischer Wandlung mit dem Soll-Wert - hier die Amplitude der aufzuzeichnenden Meßgröße - verglichen und die Regelgröße im Sinne der Angleichung an den Soll-Wert korrigiert wird. Die Anwendung dieser Regelungsmaßnahme bei einem Flüssigkeitsstrahlschreiber gemäß der Lehre der vorliegenden Erfindung führt nun insofern zu einer entscheidenden Verbesserung im Sinne der genannten Forderungen, als eine besondere Rückstellkraft für die Schreibdüse, die bisher von der Torsionskraft der Kapillare aufgebracht werden mußte, nicht mehr erforderlich ist. Denn die Winkelstellung der Kapillare wird bei der vorgeschlagenen Rückführung schon automatisch proportional dem augenblicklichen Wert der aufzuzeichnenden Meßgröße eingeregelt, so daß z.B. auch das Überschwingen beeinflußbar wird, und zwar im positiven und negativen Sinn.

Die Winkelstellung für die Rückstellung kann grundsätzlich von an sich bekannten Meßaufnehmern festgestellt und in eine elektrische Größe umgewandelt werden, die dem Regler für die notwendige Korrektur der Regelgröße zugeleitet wird. Es können mechanisch-elektrische, optisch-elektrische, magnetisch-elektrische, induktive, ohm'sche oder kapazitive Meßwertumformer benutzt werden. Insbesondere aber eignen sich für die Zwecke der Erfindung induktive mechanisch-elektrische Wandler mit einem zylindrisch in ein Magnetgestell eintauchenden Drehanker, wie sie grundsätzlich bekannt sind.

Bei einer vorteilhaften Ausbildung des Regelkreises für das Rückführungssystem gemäß dem Erfindungsgedanken wird die vom mechanisch-elektrischen Wandler (Transducer) gelieferte, der aufgenommenen Winkelstellung der Kapillare

- 7 -

proportionale elektrische Spannung als Ist-Wert dem einen
Eingang des Differenzverstärkers zugeleitet, während er
über den anderen Eingang die den Amplituden der aufzuzeichnenden Meßgröße proportionale Spannung als Soll-Wert
erhält. Der Ausgang des Verstärkers liefert dann als
Stellgröße einen der Differenz von Ist-Wert und Soll-Wert
proportionalen elektrischen Strom als Stellgröße, der als
Erregerstrom dem Elektromagneten des Antriebsmotors für
den Dauermagneten zugeleitet wird. Das auf diesen ausgeübte
Drehmoment ist also umso kleiner, je kleiner der Ausschlagsfehler, die Differenz zwischen Ist-Wert und Soll-Wert ist.
Einer besonderen Rückstellkraft, die umso größer je größer
der Erregerstrom für den Antriebsmotor ist, wie das bei bislang bekannten Flüssigkeitsstrahlschreibern der Fall ist,
bedarf es deshalb nicht.

Bei einer optischen Abtastung des Ist-Werts könnte eine
Lichtquelle mit einer in bezug auf die Drehachse der Kapillare gegenüberliegenden Photozelle zusammenarbeiten, wobei
der auf die Photozelle gerichtete Strahl je nach der Winkelstellung der Kapillare mehr oder weniger abgedeckt wird.

Mit der Erfindung wird noch eine andere Maßnahme vorgeschlagen, welche weitgehend die gestellten Aufgaben erfüllt. Sie besteht in der Anwendung eines zusätzlichen,
verwindungssteifen Kopplungselements zwischen dem Permanentmagneten des Drehmagnetwerks und der Kapillare. Bisher wurde
der Permanentmagnet, der je nach der Erregung des Magnetgestells ein Drehmoment um die Achse der Kapillare erfährt,
unmittelbar an der Kapillare selbst befestigt. Nun aber
bildet erfindungsgemäß das genannte Kopplungselement ein
Zwischenglied, vorzugsweise in der Form eines Hohlzylinders
oder einer Hohlwelle, die zentrisch die Kapillare unter Belassung eines die gegenseitige Verdrehung erlaubenden radialen Abstands zylindrisch umgibt. Dadurch ergeben sich folgende wichtige konstruktive Vorteile und Verbesserungen:

(a) Das Kopplungselement kann die zur Förderung der Schreibflüssigkeit an die Austrittsdüse dienende Kapillare unmittelbar kurz vor der Knickstelle fassen und muß erst dort an ihr befestigt sein, so daß es die Aufgaben der Halterung und Positionierung der Kapillare übernimmt.

(b) Der zur Übertragung des Drehmoments auf die Kapillare dienende Permanentmagnet muß nicht unmittelbar an der dünnen Kapillare befestigt werden, sondern wird nun an der Außenwandung des Koppelelements, also in einem größeren radialen Abstand von der Drehachse fest angebracht, was nicht nur die Kapillare, sondern besonders auch die Befestigungsstelle mechanisch entlastet.

(c) Das Magnetgestell des zum Antrieb dienenden Elektromagneten, welches einen maßgeblichen Raum beansprucht, muß nicht unmittelbar am Kapillarende angeordnet werden, was sonst zur Vermeidung von Taumelbewegungen des Kapillarendes zweckmäßig ist, sondern es kann einen größeren Abstand von der Austrittsdüse der Kapillare haben, so daß zwischen der Stelle, wo das Kopplungselement an der Kapillare befestigt ist, und der Stelle, wo der Dauermagnet am Kopplungselement sitzt, ein Drehlager für das Kopplungselement im Schreibwerkgestell angeordnet werden kann, während das zweckmäßig vorgesehene zweite Drehlager auf der anderen Seite des Dauermagneten

- 9 -

liegen mag. Somit faßt das Kopplungselement das
Ende der Kapillare, wo sie in die Austrittsdüse umbiegt, sozusagen am kurzen Zügel, und erlaubt deshalb eine genaue Justierung und vermeidet Taumelbewegungen des kapillaren Endes.

(d) Das Kopplungselement bildet schließlich, besonders
in der empfehlenswerten Ausbildung als Hohlwelle,
einen Schutz für die Kapillare, da sie wesentliche
Abschnitte derselben völlig umschließt.

(e) Da der Dauermagnet des erregenden Elektromagneten
nicht achsennah unmittelbar an der Kapillare, sondern
im Verhältnis dazu in einer größeren Entfernung von
der Achse am Kopplungselement befestigt wird, kann
der Dauermagnet stärker als bisher ausgebildet werden,
und er greift an einem längeren Hebelarm an. Die Empfindlichkeit wird dadurch gesteigert, ohne daß der
Erregerstrom im Vergleich zu bisher bekannten Flüssigkeitsstrahlschreibwerken stärker sein muß.

(f) Ein besonders großer Fortschritt liegt darin, daß
das Kopplungselement gemäß der Erfindung auch die
Funktion des Meßwertfühlers für die Winkelstellung
der Kapillare im erfindungsgemäß vorgeschlagenen
Rückführungssystem übernehmen kann. Dazu ist das
der Befestigungsstelle an der Kapillare gegenüberliegende Ende des Kopplungselements beispielsweise
als Drehanker ausgebildet und taucht zwischen die Pole
des Magnetgestells eines induktiven mechanisch-
elektrischen Wandlers.

(g) Auch wichtige fertigungstechnische Fortschritte
werden aufgrund der vorgeschlagenen Ausbildung erzielt;

- 10 -

z.B. dadurch, daß das diffizile Aufbringen eines winzigen Dauermagneten auf ein haardünnes Kapillarrohr entfällt. Vielmehr müssen jetzt an die Fertigungstoleranzen des Kapillarrohrs nicht mehr so extreme Anforderungen wie bisher gestellt werden, weil es hauptsächlich nur noch zur Tintenführung dient.

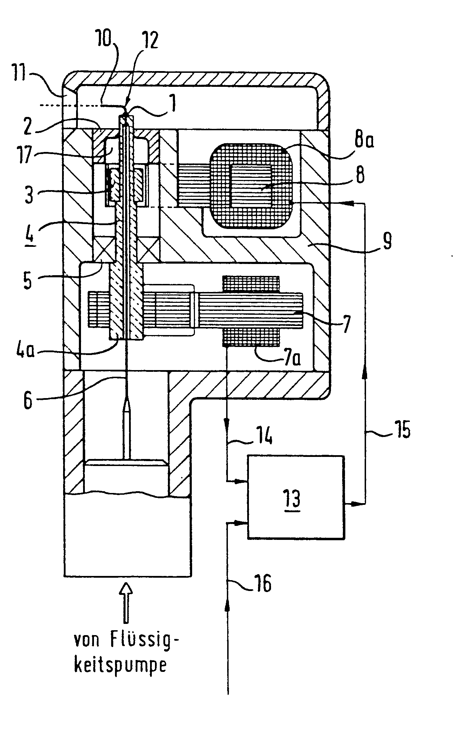

Die Erfindung und vorteilhafte Einzelheiten werden nachfolgend unter Bezug auf die Zeichnung in beispielhafter Ausführungsform näher erläutert.

Die einzige Figur zeigt unter Weglassung der Flüssigkeitspumpe einen wesentlichen Teil eines Flüssigkeitsstrahlschreibers mit Merkmalen gemäß der Erfindung in Schnittdarstellung.

In einem Gehäuse 9 eines Flüssigkeitsstrahlschreibers sind ortsfest ein Elektromagnet 8, der vom Erregerstrom gespeist wird, und ein im dargestellten Beispiel induktiver Winkelstellungsgeber 7 als Meßwertumformer gehaltert. Von einer nicht gezeigten Flüssigkeitspumpe wird über ein Filter die Schreibflüssigkeit durch die Kapillare 6 zu einer am offenen Ende abgewinkelten Schreibstrahl-Austrittsdüse 10 geführt, an der ein sehr feiner Schreibstrahl über eine Austrittsöffnung 11 am Gehäuse 9 auf eine nicht gezeigte, relativ zum Gehäuse bewegbare Papierbahn gespritzt wird. Im Inneren des Gehäuses wird die Kapillare 6 von einer Hohlwelle 4 aus nicht-magnetisierbarem Material, insbesondere aus Glas, umhüllt, die das Kopplungselement darstellt. Es ist dabei ein ringförmiger Zwischenraum belassen, der die gegenseitige Verdrehung zuläßt. Diese Hohlwelle 4 ist zweifach, um die Kapillare drehbar, gelagert, und zwar in Schreibstrahl-Strömungsrichtung einmal vor dem Elektromagneten 8 bei 5, und zum anderen stromab vom Elektromagneten 8 kurz vor ihrem Ende bei 2. Das Lager an der Stelle 5 wird vorzugsweise ein feines Kugellager sein. Auch an der Lagerstelle 2 kann ein Kugellager oder ein Gleitlager, insbesondere ein Steinlager, verwendet werden. Die Hohlwelle 4 überdeckt die Kapillare 6 bis unmittelbar vor die Knickstelle 12, wo erstere in die Schreibstrahl-Austrittsdüse 10 umgebogen ist. An ihrem vorderen Ende in unmittelbarer Nähe der Knickstelle 12 ist die Hohlwelle 4 bei 1 mit der Kapillare 6 fest verbunden, beispielsweise durch Verkleben. Das Reststück von der Verbindungs- oder Ankopplungsstelle 1 bis zur Knickstelle 12 ist sehr kurz, so daß Taumelbewegungen der Schreibspitze zwischen der Strahlaustrittsöffnung und der Ankopplungsstelle 1 ausgeschlossen sind. Die Hohlwelle 4 hat zweckmäßig eine wesentlich größere Wandungsdicke als die Kapillare und ist daher im Vergleich zu ihr praktisch verwindungssteif. Zwischen den nicht näher bezeichneten Polschuhen des Elektromagneten 8 ist beispielsweise in einer Dämpfungsflüssigkeit ein kleiner diametral magnetisierter Dauermagnet angeordnet und dort fest mit der Hohlwelle 4 verbunden, beispielsweise durch Verkleben. Wird die Wicklung 8a des Elektromagneten 8 von einem Erregerstrom, der bei der bevorzugten Ausbildung gemäß der Erfindung als Stellgröße von dem Regelverstärker 13 geliefert wird, wie im Prinzip oben schon beschrieben ist, durchflossen, so wird der Dauermagnet 8 entsprechend ausgelenkt und überträgt die Auslenkbewegung über die starre Hohlwelle 4 zur Ankopplungsstelle 1 und damit unmittelbar auf das Ende der Kapillaren und so auf die Schreibstrahl-Austrittsdüse 10.

Die Hohlwelle 4 hat die weitere wichtige Funktion, daß sie im erfindungsgemäß vorgeschlagenen Rückführungssystem als Übertragungselement für den Ist-Wert der Winkelauslenkung des Schreibstrahls von der Ankopplungsstelle 1 auf den

- 12 -

Winkelstellungsgeber 7 wirkt, der im dargestellten Beispiel als induktiver Meßwertaufnehmer gestaltet ist. Der
Winkelstellungsgeber 7 speist in der beschriebenen Weise
einen Regler 13 für den elektrischen Erregerstrom des
Elektromagneten 8.

Bei der erfindungsgemäßen Ausbildung kann vorteilhafterweise der Winkelstellungsgeber 7 für das Rückführungssystem in einem verhältnismäßig großen Abstand von dem
Drehmagnetsystem in 3, 8 und von der Befestigungsstelle 1
an der Kapillare 6 angeordnet sein, so daß keine Schwierigkeiten in bezug auf die Unterbringung des Drehmagnetsystems und des Winkelstellungsgebers im Gehäuse 9 entstehen. Die beschriebenen Teile sind vorteilhafterweise
längs der Kapillare in folgender Reihenfolge zwischen
ihrem Anschluß zur Flüssigkeitspumpe und der Austrittsdüse angeordnet: Zunächst kommt der Winkelstellungsgeber
7 mit Magnetpolen, in deren Zwischenraum das Ende des Kopplungselements 4 als Drehanker 4a eintaucht. Dann folgt ein
erstes Drehlager 5 für das Kopplungselement 4, danach die
Befestigungsstelle für den Drehmagneten 3 des Drehmagnetsystems 8 und schließlich, möglichst dicht vor der Befestigungsstelle 1 zwischen dem Kopplungselement 4 und der
Kapillare 6, ein zweites Drehlager 2, das auch eine Abdichtung für die Dämpfungsflüssigkeit sein kann, die einen
Zwischenraum zwischen den beiden Lagern ausfüllt, in welchem der Drehmagnet hin- und herschwingt.

Das übrige Reglersystem für den Erregerstrom des Elektromagneten 8, das zur Rückführung notwendig ist, ist schematisch mit 13 angedeutet, da die schaltungsmäßige Ausbildung solcher Regelkreise an sich bekannt ist. Dabei wird
der dem Ist-Wert der Winkelstellung der Kapillare entsprechende Steuerstrom in der Wicklung 7a des Wandlers 7 erzeugt und über die Leitung 14 dem Regler 13 zugeführt, wo ein Vergleich mit einer dem aufzuzeichnenden Meßsignal proportionalen elektrischen Größe, die über die Leitung 16 einem zweiten Eingang des Reglers 13 zugeleitet wird, stattfindet. Aus dem Vergleich wird eine elektrische Stellgröße gewonnen, die über die Leitung 15 an die Steuerwicklung des Magnetgestells des Drehmagnetsystems 8 geliefert wird in einem Sinne, daß die Abweichung des Ist-Werts der Winkelstellung vom Soll-Wert durch Ausübung eines entsprechenden Drehmoments auf den Dauermagneten 3 bis auf Null reduziert wird. Die bevorzugte spezielle Ausbildung ist weiter oben schon beschrieben.

Mit der Ausbildung eines Flüssigkeitsstrahlschreibers gemäß der Erfindung wird eine deutliche Verbesserung der Güteklasse der Aufzeichnungsgenauigkeit erreicht. Daneben konnten die handwerklichen Schwierigkeiten bei der Fertigung des Schreibwerks, insbesondere der Kapillare für die Zuführung der Schreibflüssigkeit, im Vergleich zu der bisher angewandten Fertigungstechnik auch wesentlich verringert werden.

- 14 -

PATENTANSPRÜCHE

1.  Flüssigkeitsstrahlschreiber mit einer Kapillare,
die zur Förderung der Schreibflüssigkeit von einem Flüssigkeitsvorrat zu ihrem einen Ende dient, an welchem sie
unter Bildung der Schreibstrahl-Austrittsdüse abgewinkelt
ist, und mit einer zur Ausübung eines Drehmoments nach
Maßgabe der Amplituden der aufzuzeichnenden Meßgröße auf
einer Kapillare dienenden elektro-magnetischen Antriebsvorrichtung, g e k e n n z e i c h n e t   d u r c h
ein Rückführungssystem für die Winkelstellung der Kapillare, das folgende Organe umfaßt:

(a) einen Meßwertaufnehmer (4), der die Winkelstellung der
    Kapillare (6) erfaßt;

(b) einen mechanisch-elektrischen Wandler (4a, 7) zur Umwandlung der Winkelstellung in ein elektrisches Signal;

(c) einen Regler (13), dem dieses elektrische Signal als
    Ist-Größe zugeleitet und mit dem Sollwert einer dem
    aufzuzeichnenden Signal proportionalen elektrischen
    Größe verglichen wird, und der dem Erregerstromkreis
    der elektromagnetischen Antriebsvorrichtung (3, 8)
    für die Kapillare (6) in einem solchen Sinne einen
    Erregerstrom als Stellgröße zuleitet, daß die Winkelstellung der Kapillare (6) an ihrem Schreibende (1)
    von dem dem aufzuzeichnenden Signal proportionalen
    Soll-Wert nicht abweicht.

2.  Flüssigkeitsstrahlschreiber nach Anspruch 1,
d a d u r c h   g e k e n n z e i c h n e t ,   daß der zur
Übertragung des Drehmoments auf die Kapillare (6) entsprechend dem aufzuzeichnenden Signal dienende, zwischen den

- 15 -

Polen der elektromagnetischen Antriebsvorrichtung (8)
angeordnete Permanentmagnet (3) an einem verwindungssteifen Kopplungselement (4) befestigt ist, das sich längs der
Kapillare (6) bis dicht vor die Stelle (12) der Umbiegung
in die Austrittsdüse (10) erstreckt und erst an dieser
Stelle (1) mit seinem einen Ende an der Kapillare befestigt
ist.

3.    Flüssigkeitsstrahlschreiber nach Anspruch 1 oder 2,
d a d u r c h   g e k e n n z e i c h n e t ,   daß das
andere Ende (4a) des Kopplungselements (4) den Meßaufnehmer
der an ihrem düsenseitigen Ende jeweils erreichten Winkelstellung der Kapillare für das Rückführungssystem bildet.

4.    Flüssigkeitsstrahlschreiber nach Anspruch 3,
d a d u r c h   g e k e n n z e i c h n e t ,   daß das
Ende (4a) des Kopplungselements als Drehanker eines induktiven mechanisch-elektrischen Wandlers (7) ausgebildet und
zwischen den Polen des Magnetgestells angeordnet ist.

5.    Flüssigkeitsstrahlschreiber nach wenigstens einem der
Ansprüche 2 bis 4,   d a d u r c h   g e k e n n z e i c h -
n e t ,   daß eine Hohlwelle oder ein Hohlzylinder (4) das
verwindungssteife Kopplungselement bildet, das zur Übertragung des Antriebs-Drehmoments vom Drehmagnet (3) auf
das düsenseitige Ende (1) der Kapillare (6) und als Winkelstellungsgeber für den mechanisch-elektrischen Wandler (7) des Rückführungssystems dient.

6.    Flüssigkeitsstrahlschreiber nach einem der vorstehenden Ansprüche,   d a d u r c h   g e k e n n z e i c h -
n e t ,   daß die Stelle (1), wo das Kopplungselement (7)
mit der Kapillare (6) fest verbunden ist, so nahe als mög-

- 16 -

lich an der Stelle (12) der Umbiegung der Kapillare (6) in die Schreibstrahl-Austrittsdüse liegt.

7. Flüssigkeitsstrahlschreiber nach einem der Ansprüche 2 bis 6, d a d u r c h   g e k e n n z e i c h n e t , daß die als Kopplungselement dienende Hohlwelle (4) aus einem nicht-magnetisierbaren Material, wie Glas, besteht.

8. Flüssigkeitsstrahlschreiber nach einem der vorstehenden Ansprüche 2 bis 7, d a d u r c h   g e k e n n - z e i c h n e t ,   daß die Hohlwelle (4) einerseits zwischen der Stelle (1) der Befestigung an der Kapillare (6) und der Lage des Dauermagneten (3) in einem Drehlager (2) und andererseits zwischen dem Dauermagneten (3) und dem anderen Ende (4a) der Hohlwelle (4), das den Drehanker für den mechanisch-elektrischen Wandler (7) bildet, in einem zweiten Drehlager (5) um ihre Achse drehbar gelagert ist.

9. Flüssigkeitsstrahlschreiber nach einem der Ansprüche 2 bis 8, d a d u r c h   g e k e n n z e i c h n e t , daß zwischen den beiden Drehlagern (2 und 5) im Schreibwerkgestell ein von den Drehlagern abgeschlossener Raum (17) zur Aufnahme einer Dämpfungsflüssigkeit für die Winkel verdrehung des Permanentmagneten (3) vorgesehen ist.

10. Flüssigkeitsstrahlschreiber nach einem der Ansprüche 2 bis 9, d a d u r c h   g e k e n n z e i c h n e t , daß das Reglersystem (13) einen Regelverstärker umfaßt, der das dem Ist-Wert der Winkelstellung der Kapillare (6) proportionale elektrische Signal mit dem der Amplitude des aufzuzeichnenden Signals proportionalen elektrischen Soll-Wert vergleicht und an seinem Ausgang als Stell-

- 17 -

größe einen Erregerstrom für den Magneten (8) der elektromagnetischen Antriebsvorrichtung liefert, der nur von
der festgestellten Abweichung zwischen Ist-Wert und Soll-
Wert abhängt.

-1-

von Flüssigkeitspumpe

| | Europäisches Patentamt | EUROPÄISCHER RECHERCHENBERICHT | Nummer der Anmeldung<br>EP 80 10 0491 |

## EINSCHLÄGIGE DOKUMENTE

| Kategorie | Kennzeichnung des Dokuments mit Angabe, soweit erforderlich, der maßgebnchen Teile | betrifft Anspruch |
|---|---|---|
| D | **DE - A - 2 619 369** (SIEMENS AG)<br>* Seite 4, Zeile 32 bis Seite 5, Zeile 16; Seite 6, Zeilen 12-18 *<br><br>-- | 1,7-9 |
| | **BE - A - 758 407** (CARDIOTEST Srl)<br>* Seite 5, Zeile 2 bis Seite 6, Zeile 32 *<br><br>---- | 1,10 |

**KLASSIFIKATION DER ANMELDUNG (Int Cl)**

G 01 D 15/18
G 01 R 17/06

**RECHERCHIERTE SACHGEBIETE (Int Cl)**

G 01 D 15/16
        15/18
G 01 R 17/06
A 61 B 5/04

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus anderin Gründen angeführtes Dokument
&: Mitglied der gleichen Patentfamilie, übereinstimmendes Dokument

X  Der vorliegende Recherchenbericht wurde für alle Patentansprüche erstellt.

| Recherchenort | Abschlußdatum der Recherche | Prüfer |
|---|---|---|
| Den Haag | 19-05-1980 | CARETTE |

EPA form 1503.1  06.78